# EUROPEAN PATENT APPLICATION

(11) **EP 1 734 585 A1**
(43) Date of publication of application: **20.12.2006**
(21) Application number: 05727856.6
(22) Date of filing: 29.03.2005
(51) Int. Cl.: H01L 27/148, H04N 5/335

(54) **IMAGING ELEMENT AND DEVICE FOR IMAGING ELEMENT EMPLOYING IT**

(30) Priority: 31.03.2004 JP 2004104836; 31.03.2004 JP 2004104837
(71) Applicant: SHIMADZU CORPORATION, Kyoto-shi, Kyoto 604-8511 (JP)
(72) Inventor: SOYA, Hideki, SHIMADZU CORPORATION, Kyoto-shi, Kyoto 6048511 (JP)
(74) Representative: Kilian, Helmut
(86) International application number: PCT/JP2005/005911
(87) International publication number: WO 2005/096385

(57) **Abstract**

In a CCD type solid-state image sensor (CCD) of this invention, a potential gradient is provided in which potentials about electric signals gradually change from a photodiode toward a gate electrode. Specifically, impurities forming the photodiode are diffused in the shape of character "X", and the width of the impurities is enlarged gradually from the photodiode toward the gate electrode. With such a gradient, the electric signals are smoothly transferred along the potential gradient, without the electric signals stagnating in movement from the photodiode to the gate electrode. As a result, the electric signals can be transferred at high speed from the photodiode to the gate electrode.

## Description

### TECHNICAL FIELD

This invention relates to an image sensor having a light receiver for receiving light by converting incident light into electric signals, and a readout unit for reading the electric signals acquired from the light receiver, and to an apparatus for an image sensor using the same.

### BACKGROUND ART

As this type of image sensor, there exists a CCD (Charge Coupled Device) type solid-state image sensor, for example. The CCD type solid-state image sensor (hereinafter abbreviated as "CCD") according to "Japanese Unexamined Patent Publication No. 2001-127277" has a photodiode corresponding to the light receiver for receiving light by converting incident light into electric signals, and a gate electrode corresponding to the readout unit for reading the electric signals acquired from the photodiode.

The photodiode generates electric signals proportional to the quantity of incident light, i.e. exposed light. Generally, a digital camera using a CCD, for example, adjusts the quantity of exposed light and exposure time of the photodiode by a mechanical shutter or electronic shutter.

However, when a CCD is used in a high-speed imaging apparatus, there is a drawback that electric signals cannot be transferred smoothly.

Specific problems include the following problems (i) and (ii):

### Regarding problem (i)

In high-speed imaging, exposure time is short. Therefore, light exposure decreases, with the result that the quantity of electric signals generated by the photodiode also decreases. Then, it is conceivable to increase light exposure by emitting light toward the photodiode with a powerful lighting or by enlarging the area of the photodiode. However, when the area of the photodiode is enlarged to increase light exposure, the distance from the photodiode to the gate electrode becomes long, and the time for transfer from the photodiode to the gate electrode becomes long. As a result, the time for transfer from the photodiode through the gate electrode also becomes long, thereby making transfer at high speed difficult. Thus, when high-speed imaging is performed, light exposure will decrease. There is a problem that high-speed imaging is impossible when the area of the photodiode is enlarged in order to increase light exposure.

### Regarding problem (ii)

In the case of a mechanical shutter, exposure time is adjusted by physically shutting off incident light. Specifically, a light shielding plate or the like is moved to shut off light. Since exposure time is short in high-speed imaging, light shielding by a mechanical shutter is of no use. It takes time in the order of milliseconds to move the light shielding plate to shut off light completely. When, for example, exposure time is 1.0 × 10⁻⁴ seconds (100µs), exposure will take place for a longer time than the actual exposure time before light is shut off completely.

On the other hand, in the case of an electronic shutter, exposure time can be adjusted electrically. Even if exposure time is as short as 100 µs, a desired exposure time can be set. When an overexposure occurs within exposure time, that is when electric signals exceeding a signal quantity storable in a photodiode are generated within exposure time, excess part of the electric signals in the photodiode will flow to the readout unit, causing a phenomenon called "blooming". When a blooming takes place, the signals will leak vertically (lengthwise direction), producing elongated lines in an image picked up. In order to prevent blooming, drain structures are provided as in the above-mentioned publication.

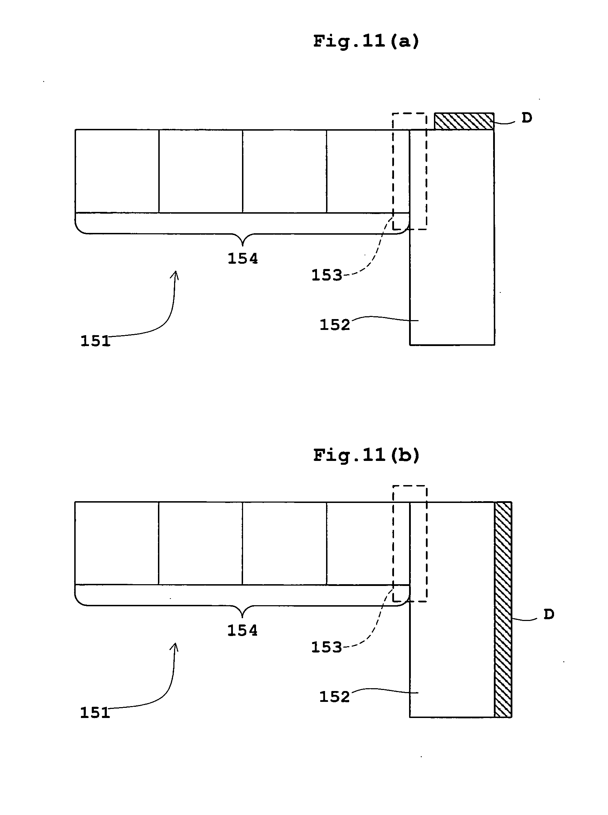

Fig. 11 is a block diagram showing a construction of a CCD type solid-state image sensor having drain structures. In Fig. 11, the CCD is provided with CCD cells for storage. CCD 151, as noted above, has a photodiode 152, a gate electrode 153, and a plurality of (four in Fig. 11) storage CCD cells 154 for storing electric signals read by the gate electrode 153. In positions as shown in Fig. 11 (a) or 11 (b), drain structures D are provided adjacent the photodiode 152.

By providing such drain structures D, excess part of the electric signals in the photodiode 152 can be discharged. It is also possible to adjust the quantity of electric signals discharged by the drain structures by adjusting a gate voltage applied to a gate electrode (not shown) disposed between the photodiode 152 and drain structures D. An electronic shutter can realize the same function as a mechanical shutter by discharging all electric signals generated in the photodiode 152 to the drain structures except at exposure time.

However, the CCD provided with these storage CCD cells has the following problems.

As noted above, since exposure time is short in high-speed imaging, light exposure decreases. Thus, light exposure is increased by emitting light toward the photodiode from a powerful lighting, or enlarging the area of the photodiode. On the other hand, to cope with high-speed imaging, as shown in Fig. 11, the storage CCD cells 154 are provided to store electric signals successively in each storage CCD cell 154 during the short exposure time and transfer them to adjoining storage CCD cell 154 in order. In this case, in order to secure a large number of storage units (memories), it is necessary to make the area of each storage CCD cell 154 as small as possible.

When the area of the photodiode is enlarged to increase light exposure, the signal quantity storable in the photodiode increases far larger than the signal quantity storable in the storage CCD cells. Because of the large difference in the signal quantity, it becomes difficult to make an adjustment to the signal quantity storable in the storage CCD cells only by the drain structures noted above.

Having regard to the above-noted situation, the object of this invention is to provide an image sensor and an apparatus for an image sensor using the same, which can transfer electric signals at high speed, and particularly, (i) can transfer electric signals at high speed from a light receiver to a readout unit, and (ii) can adjust, in a simple way, the quantity of electric signals stored in storage units, and transfer the electric signals smoothly downstream of the storage units.

### DISCLOSURE OF THE INVENTION

An image sensor of this invention created in order to solve the problem (i) noted above is an image sensor comprising a light receiver for receiving light by converting incident light into electric signals, and a readout unit for reading the electric signals acquired from the light receiver, characterized in that a potential gradient is provided in which potentials about the electric signals gradually change from the light receiver toward the readout unit.

According to the image sensor of this invention, the light receiver receives light by converting incident light into electric signals, and the readout unit reads the electric signals acquired from the light receiver. At this time, with the potential gradient provided in which potentials about electric signals change gradually from the light receiver toward the readout unit, the electric signals are smoothly transferred along the potential gradient, without the electric signals stagnating in movement from the light receiver to the readout unit. As a result, the electric signals can be transferred at high speed from the light receiver to the readout unit.

An apparatus for an image sensor of this invention created in order to solve the problem (i) noted above is an apparatus for an image sensor using an image sensor comprising a light receiver for receiving light by converting incident light into electric signals, and a readout unit for reading the electric signals acquired from the light receiver, characterized in that a potential gradient is provided in which potentials about the electric signals gradually change from the light receiver toward the readout unit.

According to the apparatus for an image sensor of this invention, with the potential gradient provided in which potentials about electric signals change gradually from the light receiver toward the readout unit, the electric signals are smoothly transferred along the potential gradient, without the electric signals stagnating in movement from the light receiver to the readout unit, whereby the electric signals can be transferred at high speed from the light receiver to the readout unit.

In these inventions created in order to solve the problem (i) noted above, examples of the potential gradient include the following. For example, a potential gradient may be provided by gradually enlarging a width of impurities forming the light receiver, from the light receiver to the readout unit. A potential gradient may be provided by gradually increasing density of impurities forming the light receiver, from the light receiver to the readout unit.

In the apparatus for an image sensor, the apparatus may be used as an analysis apparatus for performing analysis using data of electric signals acquired with the image sensor, a transfer apparatus for storing only data and transferring the stored data to an external apparatus, or an imaging apparatus that takes in optical images of a photographic subject, with the light receiver converting the taken-in optical images into electric signals, and has a crystalline lens for taking in the optical images of the photographic subject. In the case of an imaging apparatus, a crystalline lens is provided for taking in the optical images of the above photographic subject. This invention is useful particularly where the imaging apparatus transfers the electric signals at high speed, such as a high-speed imaging apparatus with a photographic speed, for example, of 1.0 × 10⁶ frames per second (1,000,000 frames per second). In this specification, a photographic speed of 100,000 or more frames per second is called "high-speed photography".

To solve the problem (ii) noted above, Inventor has made intensive research and attained the following findings.

That is, attention was paid to Patent Document 1 noted hereinbefore. In this publication, drain structures are provided not only in the vertical direction but also in the horizontal direction to prevent blooming. In this publication it is not a CCD type solid-state image sensor with storage units represented by storage CCD cells, for example, consideration has been made as to applying to an image sensor with storage units. That is, it has been thought out to discharge excess part of the electric signals read by a readout unit represented by a gate electrode, by providing, when storage CCD cells are provided, a drain structure at least in a direction of arrangement of the storage CCD cells. Further, it has been thought that the problem (ii) noted above can be solved when the drain structure is provided as far upstream as possible rather than downstream. That is, since excess part of the electric signals in the upstream side will flow to each storage CCD even if a drain structure is provided downstream, it is provided in a portion corresponding to an upstream position, i.e. adjacent the storage unit adjacent the readout unit, or adjacent the readout unit, to discharge excess electric signals beforehand in the upstream position. And it has been found that flowing into the downstream side is prevented, and the quantity of electric signals for storage can be adjusted in a simple way in the upstream position.

An image sensor of this invention created in order to solve the problem (ii) noted above, and based on such findings, is an image sensor comprising a light receiver for receiving light by converting incident light into electric signals, a readout unit for reading the electric signals acquired from the light receiver, and a plurality of storage units for storing the electric signals read by the readout unit, characterized in that a first drain structure is disposed adjacent a storage unit adjacent the readout unit or the readout unit for discharging excess part of the electric signals read by the readout unit.

According to the image sensor of this invention, the light receiver receives light by converting incident light into electric signals, and the readout unit reads the electric signals acquired from the light receiver. And each storage unit stores the electric signals read by the readout unit, respectively. At this time, with the first drain structure disposed adjacent the storage unit adjacent the readout unit, or the readout unit, for discharging excess part of the electric signals read by the readout unit, the electric signals can be smoothly transferred downstream of the storage units. With the first drain structure discharging such excess part, it is possible to adjust, in a simple way, the quantity of electric signals stored in the storage units.

An apparatus for an image sensor of this invention created in order to solve the problem (ii) noted above is an apparatus for an image sensor using an image sensor comprising a light receiver for receiving light by converting incident light into electric signals, a readout unit for reading the electric signals acquired from the light receiver, and a plurality of storage units for storing the electric signals read by the readout unit, characterized in that a first drain structure is disposed adjacent a storage unit adjacent the readout unit or the readout unit for discharging excess part of the electric signals read by the readout unit.

According to the apparatus for an image sensor of this invention, with the first drain structure disposed adjacent the storage unit adjacent the readout unit, or the readout unit, for discharging excess part of the electric signals read by the readout unit, it is possible to adjust, in a simple way, the quantity of electric signals stored in the storage units, and transfer the electric signals smoothly downstream of the storage units.

In these inventions created in order to solve the problem (ii) noted above, it is preferable that the above image sensor further includes a second drain structure disposed adjacent the light receiver for discharging excess part of the electric signals in the light receiver. By further providing this second drain structure, it is possible to prevent the blooming that occurs as excess part of the electric signals in the light receiver flow to the readout unit.

In the invention created in order to solve the problem (ii) noted above, as in the invention created in order to solve the problem (i) noted above, the apparatus may be used as an analysis apparatus for performing analysis using data of electric signals acquired with the image sensor, a transfer apparatus for storing only data and transferring the stored data to an external apparatus, or an imaging apparatus that takes in optical images of a photographic subject, with the light receiver converting the taken-in optical images into electric signals, and has a crystalline lens for taking in the optical images of the photographic subject. In the case of an imaging apparatus, a crystalline lens is provided for taking in the optical images of the above photographic subject. This invention is useful particularly where the imaging apparatus transfers the electric signals at high speed, such as a high-speed imaging apparatus with a photographic speed, for example, of 1.0 × 10⁶ frames per second (1,000,000 frames per second).

### BRIEF DESCRIPTION OF THE DRAWINGS

Fig. 1 is a block diagram showing a construction of a CCD type solid-state image sensor (CCD) in Embodiment 1;
Fig. 2 (a) is a plan view showing a construction of each photodiode forming the CCD;
Fig. 2 (b) is a schematic view of a potential shape in section A-B of Fig. 2 (a);
Fig. 3 (a) is an explanatory view of a conventional CCD for comparison with Fig. 2, and is a plan view showing a construction of each photodiode forming the CCD;
Fig. 3 (b) is an explanatory view of the conventional CCD for comparison with Fig. 2, and is a schematic view of a potential shape in section A-B of Fig. 3 (a);
Fig. 4 is a block diagram showing an outline of a high-speed imaging apparatus using the CCD in Embodiment 1;
Fig. 5 is a plan view showing a construction of each photodiode forming a CCD in Embodiment 2;
Fig. 6 is a block diagram showing a construction of a CCD type solid-state image sensor (CCD) in Embodiment 3;
Fig. 7 is a block diagram showing a construction of each photodiode forming the CCD;
Fig. 8 is a block diagram showing an outline of a high-speed imaging apparatus using the CCD in Embodiment 3;
Fig. 9 is a plan view showing a construction of each photogate according to the invention created in order to solve problem (i);
Fig. 10 is a block diagram showing a construction of each photodiode forming a CCD in a modification of Embodiment 3 of the invention created in order to solve problem (ii);
Fig. 11 (a) is a block diagram showing a construction of a conventional CCD type solid-state image sensor (CCD); and
Fig. 11 (b) is a block diagram showing the construction of the conventional CCD type solid-state image sensor (CCD).

### BEST MODE FOR CARRYING OUT THE INVENTION

Modes for solving the problems of the prior art include the following.

### <Embodiment 1>

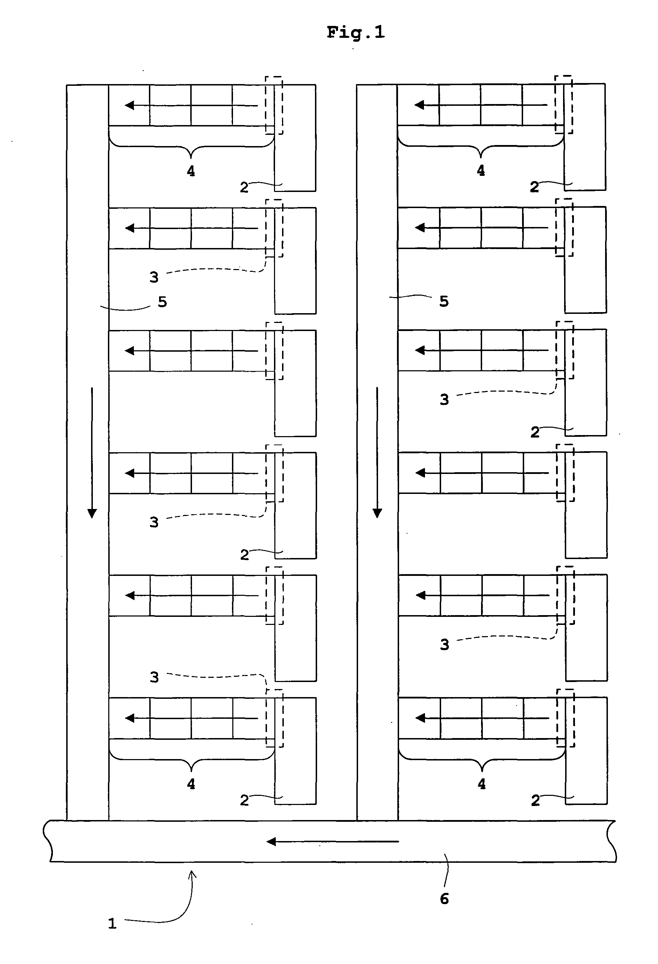

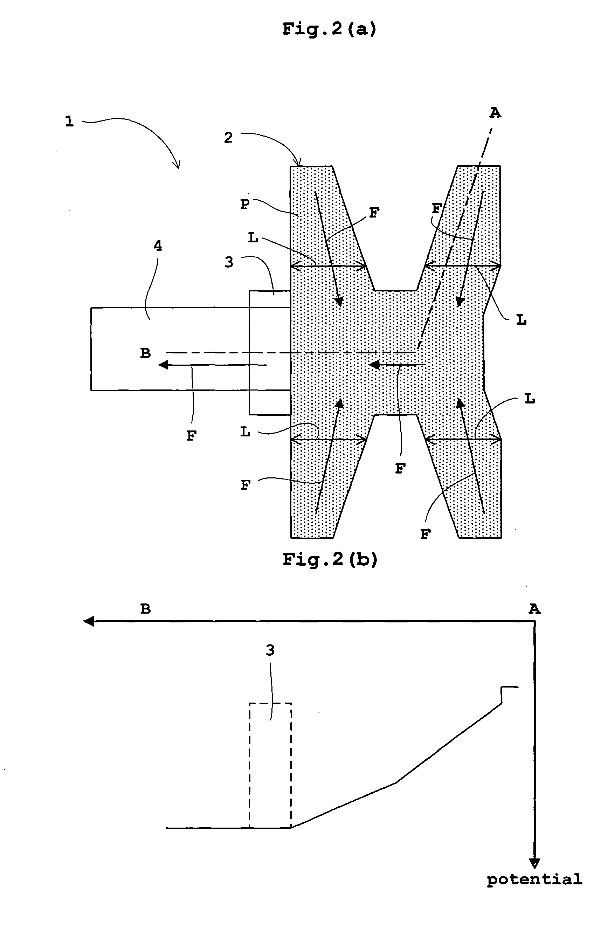

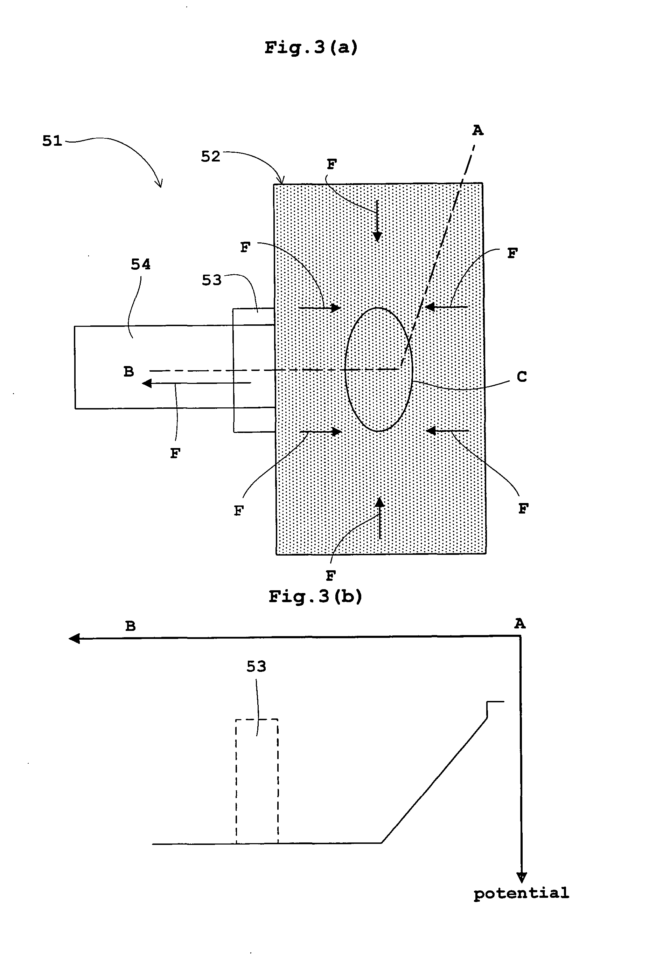

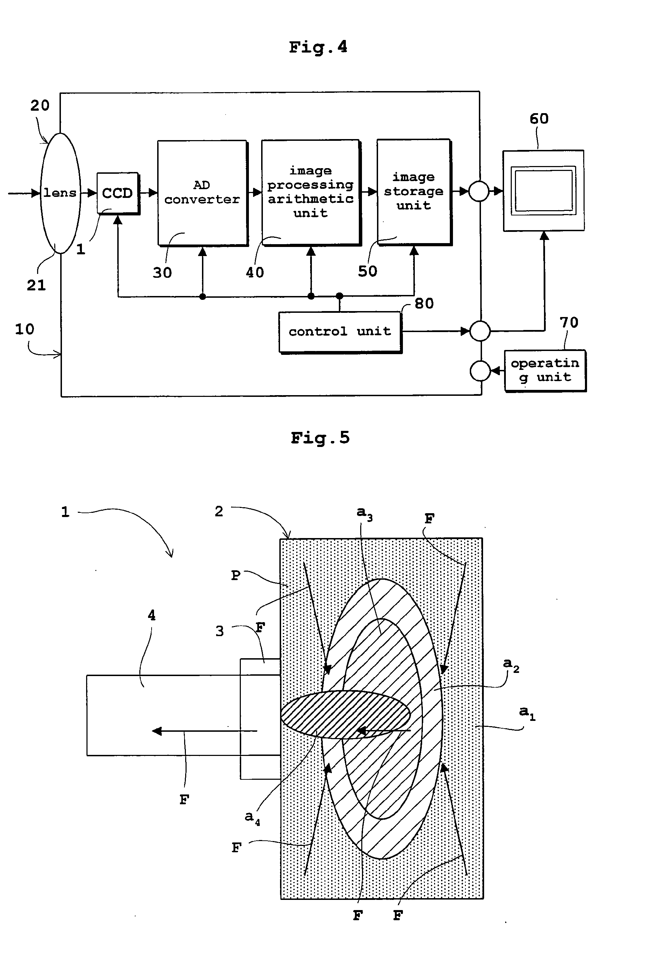

Embodiment 1 of this invention will be described hereinafter with reference to the drawings. Fig. 1 is a block diagram showing a construction of a CCD type solid-state image sensor device (CCD). Fig. 2 (a) is a plan view showing a construction of each photodiode forming the CCD. Fig. 2 (b) is a schematic view of a potential shape in section A-B of Fig. 2 (a). Fig. 3 (a) is an explanatory view of a conventional CCD for comparison with Fig. 2, in which Fig. 3 (a) is a plan view showing a construction of each photodiode forming the CCD, and Fig. 3 (b) is a schematic view of a potential shape in section A-B of Fig. 3 (a). Fig. 4 is a block diagram showing an outline of a high-speed imaging apparatus using the CCD in Embodiment 1.

CCD 1, as shown in Fig. 1, includes a photodiode 2 for receiving light by converting incident light into electric signals, a gate electrode 3 for reading the electric signals acquired from the photodiodes 2, and a plurality of (four in Fig. 1) storage CCD cells 4 for storing the electric signals read by the gate electrode 3. The CCD 1 corresponds to the image sensor in this invention. The photodiode 2 corresponds to the light receiver in this invention. The gate electrode 3 corresponds to the readout unit in this invention.

The most downstream storage CCD cell 4 among the storage CCD cells 4 is connected to a vertical transfer path 5, and each vertical transfer path 5 is connected to a horizontal transfer path 6. The electric signals read by the gate electrode 3 are successively stored in each CCD cell 4. Each time a charge transfer signal synchronized with an electronic shuttering operation is applied as a gate voltage to the gate electrode 3, the signals are transferred to adjoining storage CCD cells 4 in order in the direction indicated by arrows in Fig. 1. When all electric charges are stored as electric signals in the storage CCD cells 4 arranged horizontally, they are transferred vertically to the vertical transfer path 5 and transferred horizontally to the horizontal transfer path 6.

The electric signals transferred in this way are outputted to the exterior of the CCD1 (to an AD converter and an image processing arithmetic unit of the high-speed imaging apparatus), where various processes are performed to output images.

As shown in Fig. 2, a potential gradient P is provided in which potentials about electric signals gradually change from the photodiode 2 toward the gate electrode 3. The conventional CCD of Fig. 3 will also be described for comparison with Fig. 2. The portions of the photodiodes in Fig. 2 and Fig. 3 comprise diffusion regions of impurities, and thus correspond also to regions of impurities.

As shown in Fig. 3 (a), the conventional CCD 51 has a photodiode 52 of rectangular shape. Line A-B of Fig. 3 (a) includes the photodiode 52 to a gate electrode 53, and a potential shape in section A-B is as shown in Fig. 3 (b). That is, after the potential becomes high from a peripheral portion of the photodiode 52 to near the center, the potential of the same level is maintained from near the center to the gate electrode 53. Therefore, flows F of electric signals in Fig. 3 (a) move toward the center, and the electric signals stagnate near the center of the photodiode 52 (see near the center C of Fig. 3 (a)).

On the other hand, as shown in Fig. 2 (a), the CCD 1 in Embodiment 1 has the photodiode 2 shaped like character "X". The impurities forming the photodiode 2 have a width "L" as shown Fig. 2 (a). The photodiode 2 shaped like character "X" has the width L of impurities gradually enlarging from the photodiode 2 toward the gate electrode 3. Line A-B of Fig. 2 (a) includes the photodiode 2 to the gate electrode 3, and a potential shape in section A-B is as shown in Fig. 2 (b). That is, as shown in Fig. 2 (b), even after the potential becomes high gently from a peripheral portion of the photodiode 2 to near the center, the potential gradually changes from near the center to the gate electrode. Therefore, flows F of electric signals in Fig. 2 (b) move toward the gate electrode 3 even after moving near the center, and the electric signals do not stagnate in movement from the photodiode 2 to the gate electrode 3.

In a process of manufacturing the CCD, the photodiode 2 may be constructed by diffusing (doping) impurities in the shape of character "X" as shown in Fig. 2 (a). With the photodiode 2 constructed in this way, the potential gradient P is formed in which potentials about electric signals change gradually from the photodiode 2 toward the gate electrode 3.

In Embodiment 1, the CCD 1 shown in Figs. 1 and 2 is used in a high-speed imaging apparatus 10 shown in Fig. 4. Embodiment 1 uses the high-speed imaging apparatus 10 with a photographic speed of 1.0 × 10⁶ frames per second (1,000,000 frames per second). The high-speed imaging apparatus 10 is constructed to take in optical images of a photographic subject, with the photodiode 2 converting the taken-in optical images into electric signals, thereby imaging the photographic subject. That is, the high-speed imaging apparatus includes optics 20, CCD 1, an AD converter 30, an image processing arithmetic unit 40, an image storage unit 50, a monitor 60, an operating unit 70 and a control unit 80. The high-speed imaging apparatus 10 corresponds to the apparatus for an image sensor in this invention.

The optics 20 include a lens 21 for taking in the optical images of the photographic subject, a photo multiplier mechanism such as an image intensifier (not shown) and a mechanical shuttering mechanism (not shown). The AD converter 30 converts the electric signals outputted from the CCD 1 into digital signals. The image processing arithmetic unit 40 performs various arithmetic processes in order to create two-dimensional images of the photographic subject based on the electric signals digitized by the AD converter 30. The image storage unit 50 stores the two-dimensional images created by the image processing arithmetic unit 40. The monitor 60 outputs the two-dimensional images stored in the image storage unit 50 to a screen. The operating unit 70 performs various operations required for execution of high-speed imaging. The control unit 80 carries out an overall control of the entire apparatus according to controls such as photographing conditions set by the operating unit 70. The lens 21 corresponds to the crystalline lens in this invention.

According to the above CCD 1 and the high-speed imaging apparatus 10 using it, the photodiode 2 receives light by converting incident light into electric signals, and the gate electrode 3 reads the electric signals acquired from the photodiode 2. At this time, with the potential gradient P provided in which potentials about electric signals change gradually from the photodiode 2 toward the gate electrode 3, the electric signals are smoothly transferred along the potential gradient P, without the electric signals stagnating in movement from the photodiode 2 to the gate electrode 3. As a result, the electric signals can be transferred at high speed from the photodiode 2 to the gate electrode 3.

In Embodiment 1, the potential gradient P is provided by gradually enlarging the width L of impurities forming the photodiode 2, from the photodiode 2 toward the gate electrode 3.

This invention is particularly useful where the electric signals are transferred at high speed as in the high-speed imaging apparatus 10 in Embodiment 1.

### <Embodiment 2>

Next, Embodiment 2 of this invention will be described with reference to the drawings. Fig. 5 is a plan view showing a construction of each photodiode forming a CCD in Embodiment 2.

In Embodiment 2, CCD 1 has a photodiode 2 of rectangular shape which is the same shape as the photodiode 52 of the conventional CCD 51 (see Fig. 3). The density of impurities forming the photodiode 2 is diffused (doped) to be gradually higher from the photodiode 2 toward the gate electrode 3. When the portion of the photodiode 2 is divided into regions a₁, a₂, a₃ and a₄ as shown in Fig. 5, for example, the density of impurities doped is higher in the order of regions a₁, a₂, a₃ and a₄. With the photodiode 2 constructed in this way, a potential gradient P is formed in which potentials about electric signals change gradually from the photodiode 2 toward the gate electrode 3.

According to Embodiment 2, the potential gradient P is provided by gradually increasing the density of impurities forming the photodiode 2, from the photodiode 2 toward the gate electrode 3.

Such photodiode 2 may be used for the CCD 1 in Embodiment 1 (see Fig. 1), and may be used for the high-speed imaging apparatus in Embodiment 1 (see Fig. 4).

### <Embodiment 3>

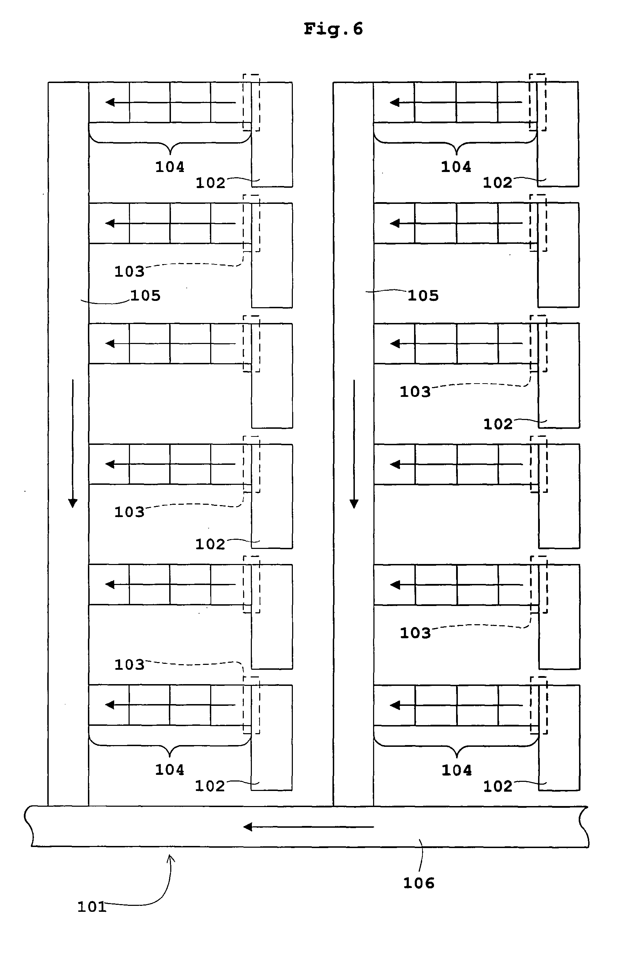

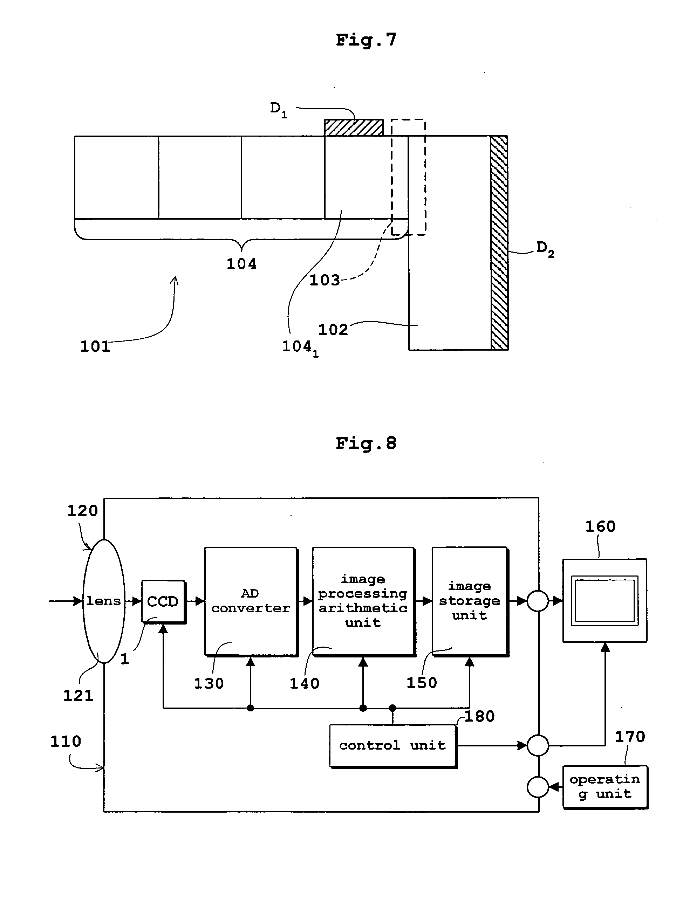

Next, Embodiment 3 of this invention will be described with reference to the drawings. Fig. 6 is a block diagram showing a construction of a CCD type solid-state image sensor (CCD) in Embodiment 3. Fig. 7 is a block diagram showing a construction of each photodiode forming the CCD. Fig. 8 is a block diagram showing an outline of a high-speed imaging apparatus using the CCD in Embodiment 3.

The entire construction of the CCD in Embodiment 3 is the same as the entire construction of the CCD in Embodiment 1 except the storage CCD cell adjacent the photodiode and gate electrode (see Fig. 1). In order to distinguish from Embodiment 1, in Embodiment 3, the CCD is referenced "101", the photodiode is referenced "102", the gate electrode is referenced "103", the storage CCD cells are referenced "104", the vertical transfer paths are referenced "105", and the horizontal transfer path is referenced "106".

The high-speed imaging apparatus using the CCD 101 according to Embodiment 3 is the same as the high-speed imaging apparatus in Embodiment 1 (see Fig. 4). In accordance with the references being changed in Embodiment 3, the optics in Embodiment 3 are referenced "120", the lens is referenced "121", the AD converter is referenced "130", the image processing arithmetic unit is referenced "140", the image storage unit is referenced "150" the monitor is referenced "160", the operating unit is referenced "170", and the control unit is referenced "180".

In Embodiment 3, as in Embodiment 1, the CCD 101 includes the photodiode 102, gate electrode 103, the plurality of storage CCD cells 104, vertical transfer paths 105 and horizontal transfer path 106. The CCD 101 corresponds to the image sensor in this invention. The photodiode 102 corresponds to the light receiver in this invention. The storage CCD cells 104 correspond to the storage units in this invention. The gate electrode 103 corresponds to the readout unit in this invention.

In order to discharge excess part of the electric signals read by the gate electrode 103, as shown in Fig. 7, a first drain structure D1 is disposed vertically adjacent the storage CCD cell 104 adjacent the gate electrode 103. In order to distinguish the storage CCD cell 104 adjacent the gate electrode 103 from the other storage CCD cells 104, the following description will be made in which the storage CCD cell 104 adjacent the gate electrode 103 is specially referred to as "adjacent cell 1041". The first drain structure D1 corresponds to the first drain structure in this invention. The first drain structure D1 may be disposed adjacent the gate electrode 103.

In order to discharge excess part of the electric signals in the photodiode 102 to prevent blooming, as shown in Fig. 7, a second drain structure D2 is disposed adjacent the photodiode 102. The second drain structure D2 corresponds to the second drain structure in this invention.

In Embodiment 3, the CCD 101 shown in Figs. 6 and 7 is used in a high-speed imaging apparatus similar to Embodiment 1. Embodiment 3 also uses the high-speed imaging apparatus 110 with a photographic speed of 1.0 × 10⁶ frames per second (1,000,000 frames per second). The high-speed imaging apparatus 110 is constructed to take in optical images of a photographic subject, with the photodiode 102 converting the taken-in optical images into electric signals, thereby imaging the photographic subject. That is, the high-speed imaging apparatus includes the optics 120, CCD 101, AD converter 130, image processing arithmetic unit 140, image storage unit 150, monitor 160, operating unit 170 and control unit 180. The high-speed imaging apparatus 110 corresponds to the apparatus for an image sensor in this invention.

The optics 120 and other aspects of the high-speed imaging apparatus 110 are the same as in Embodiment 1, and their description will not be omitted.

According to the above CCD 101 and the high-speed imaging apparatus 110 using it, the photodiode 102 receives light by converting incident light into electric signals, and the gate electrode 103 reads the electric signals acquired from the photodiode 102. And each storage CCD cell 104 stores the electric signals read by the gate electrode 103, respectively. At this time, with the first drain structure D1 disposed adjacent the adjacent cell 1041 adjacent the gate electrode 103, i.e. the cell 1041 most upstream among the storage CCD cells 104, for discharging excess part of the electric signals read by the gate electrode 103, the electric signals can be smoothly transferred downstream of the storage CCD cells 104. With the first drain structure D1 discharging such excess part, it is possible to adjust, in a simple way, the quantity of electric signals stored in the storage CCD cells 104.

In Embodiment 3, in order to prevent blooming, the second drain structure D2 is disposed adjacent the photodiode 102 as shown in Fig. 7, for discharging excess part of the electric signals in the photodiode 102. By further providing this second drain structure D2, it is possible to prevent the blooming that occurs as excess part of the electric signals in the photodiode 102 flow to the readout unit.

This invention is particularly useful where the electric signals are transferred at high speed as in the high-speed imaging apparatus 110 in Embodiment 3.

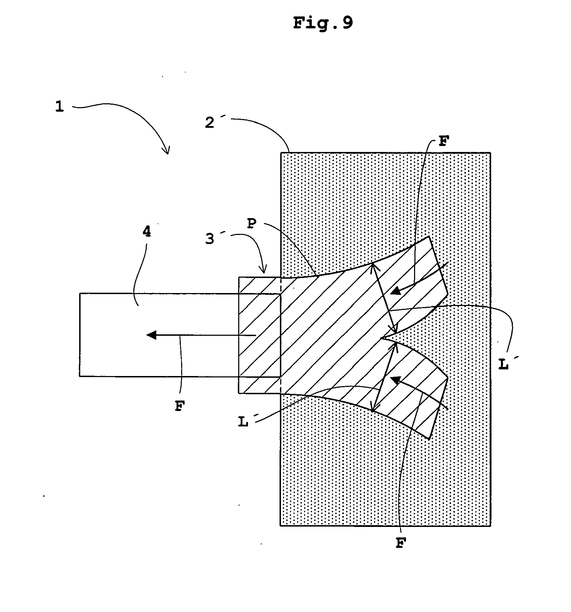

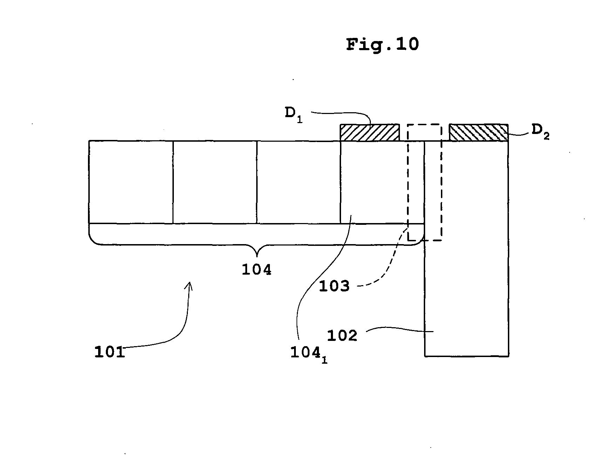

This invention is not limited to the foregoing embodiments, but may be modified as follows:
(1) While each foregoing embodiment has been described by taking the high-speed imaging apparatus for example, it is possible to use an ordinary imaging apparatus with a photographic speed of 100,000 frames per second.
(2) While each foregoing embodiment has been described by taking for example an imaging apparatus represented by the high-speed imaging apparatus as the apparatus for an image sensor using an image sensor represented by the CCD or the like, this is not limitative but any apparatus using an image sensor is acceptable. It is possible to use the apparatus, for example, as an analysis apparatus for performing analysis using data of electric signals acquired with the image sensor, or a transfer apparatus for storing only data and transferring the stored data to an external apparatus.
(3) While each foregoing embodiment has been described by taking a photodiode for example of light receiver, this is not limitative. For example, a photogate may be used as the light receiver.
   Particularly when the invention made in order to solve the problem (i) noted hereinbefore is applied to a photogate, that is when a photogate is used as the light receiver in Embodiments 1 and 2, a potential gradient may be provided by the shape of a photogate electrode. For example, as shown in Fig. 9, a photogate electrode 3' is made in a shape of character "Y". And a potential gradient P may be provided by gradually enlarging width L' of the photogate electrode 3' toward a readout direction. When reading electric signals, a greater voltage is applied to the photogate electrode 3' than to a photogate electrode 2' to facilitate movement in the readout direction. In the case of the photogate also, the density and shape of impurities forming the photogate may be set as in the embodiments. A potential gradient may be provided by impurities, and a potential gradient may be provided also by the shape of the photogate electrode.
(4) In Embodiment 1 described hereinbefore, as shown in Fig. 2, the photodiode 2 is shaped like character "X" and the width L of impurities is gradually enlarged from the photodiode 2 toward the gate electrode 3. However, the shape of the photodiode 2 is not limitative.
(5) Embodiment 1 and Embodiment 2 described hereinbefore may be combined. That is, the width L of impurities may be gradually enlarged from the photodiode 2 toward the gate electrode 3, and the density of impurities may be increased from the photodiode 2 toward the gate electrode 3.
(6) Although the second drain structure is further provided in Embodiment 3 described hereinbefore, when no blooming occurs or blooming is not taken into consideration, it is not absolutely necessary to provide the second drain structure.
(7) Although, in Embodiment 3 described hereinbefore, as shown in Fig. 7, the second drain structure D2 is disposed in the position shown in Fig. 7 adjacent the photodiode 102, it may be disposed in a position as shown in Fig. 10, adjacent the photodiode 102. Thus, only if disposed adjacent the photodiode 102, the position of the second drain structure D2 is not limited in particular.
(8) Embodiment 1 and Embodiment 3 described hereinbefore, Embodiment 2 and Embodiment 3, or all of Embodiment 1 to Embodiment 3, may be combined.

### INDUSTRIAL UTILITY

As noted hereinbefore, this invention is suitable for high-speed photography with a photographic speed of 100,000 or more frames per second.

## Claims

1. An image sensor comprising a light receiver for receiving light by converting incident light into electric signals, and a readout unit for reading the electric signals acquired from the light receiver, **characterized in that** a potential gradient is provided in which potentials about the electric signals gradually change from the light receiver toward said readout unit.

2. An image sensor as defined in claim 1, **characterized in that** said potential gradient is provided by gradually enlarging a width of impurities forming said light receiver, from the light receiver to said readout unit.

3. An image sensor as defined in claim 1, **characterized in that** said potential gradient is provided by gradually increasing density of impurities forming said light receiver, from the light receiver to said readout unit.

4. An image sensor as defined in claim 1, **characterized in that** said light receiver is a photodiode.

5. An image sensor as defined in claim 1, **characterized in that** said light receiver is a photogate.

6. An apparatus for an image sensor using an image sensor comprising a light receiver for receiving light by converting incident light into electric signals, and a readout unit for reading the electric signals acquired from the light receiver, **characterized in that** a potential gradient is provided in which potentials about the electric signals gradually change from the light receiver toward said readout unit.

7. An apparatus for an image sensor as defined in claim 6, **characterized in that** said potential gradient is provided by gradually enlarging a width of impurities forming said light receiver, from the light receiver to said readout unit.

8. An apparatus for an image sensor as defined in claim 6, **characterized in that** said potential gradient is provided by gradually increasing density of impurities forming said light receiver, from the light receiver to said readout unit.

9. An apparatus for an image sensor as defined in claim 6, **characterized in that** said apparatus is used as an imaging apparatus that takes in optical images of a photographic subject, with said light receiver converting the taken-in optical images into electric signals, and has a crystalline lens for taking in the optical images of said photographic subject.

10. An image sensor comprising a light receiver for receiving light by converting incident light into electric signals, a readout unit for reading the electric signals acquired from the light receiver, and a plurality of storage units for storing the electric signals read by the readout unit, **characterized in that** a first drain structure is disposed adjacent a storage unit adjacent the readout unit or the readout unit for discharging excess part of the electric signals read by said readout unit.

11. An image sensor as defined in claim 10, **characterized in that** said sensor further includes a second drain structure disposed adjacent the light receiver for discharging excess part of said electric signals in said light receiver.

12. An image sensor as defined in claim 10, **characterized in that** said light receiver is a photodiode.

13. An image sensor as defined in claim 10, **characterized in that** said light receiver is a photogate.

14. An apparatus for an image sensor using an image sensor comprising a light receiver for receiving light by converting incident light into electric signals, a readout unit for reading the electric signals acquired from the light receiver, and a plurality of storage units for storing the electric signals read by the readout unit, **characterized in that** a first drain structure is disposed adjacent a storage unit adjacent the readout unit or the readout unit for discharging excess part of the electric signals read by said readout unit.

15. An apparatus for an image sensor as defined in claim 14, **characterized in that** said sensor further includes a second drain structure disposed adjacent the light receiver for discharging excess part of said electric signals in said light receiver.

16. An apparatus for an image sensor as defined in claim 14, **characterized in that** said apparatus is used as an imaging apparatus that takes in optical images of a photographic subject, with said light receiver converting the taken-in optical images into electric signals, and has a crystalline lens for taking in the optical images of said photographic subject.
